# EUROPEAN PATENT APPLICATION

(11) **EP 4 667 952 A1**
(43) Date of publication of application: **24.12.2025**
(21) Application number: 25181257.4
(22) Date of filing: 06.06.2025
(51) Int. Cl.: G01R 31/3185

(54) **METHOD FOR TESTING A COUNTER, CORRESPONDING PROCESSING SYSTEM AND COMPUTER PROGRAM PRODUCT**

(30) Priority: 21.06.2024 IT 202400014419
(71) Applicant: STMicroelectronics International N.V., 1228 Plan-les-Ouates, Geneva (CH)
(72) Inventor: SCIBETTA, Roberto, 20862 Arcore (Monza Brianza) (IT); MACALUSO, Ruggero, 20099 Sesto San Giovanni (IT)
(74) Representative: Buzzi, Notaro & Antonielli d'Oulx S.p.A.

(57) **Abstract**

Solutions for testing a digital hardware counter circuit (108) are disclosed. A software module (1022) executed by a microprocessor (102) is configured to test a plurality of most significant bits of a count value (CNT) of a counter (1080) of the counter circuit (108) by repeating a sequence of steps for each bit position (N) of the plurality of most significant bits of the count value (CNT). Specifically, the software module (1022) sets (5004) the count value (CNT) to a binary value (T). **In** case of a down counter (1080), the bit of the binary value (T) at the current bit position (N) is set to high and the lower bits of the binary value (T) are set to low. Conversely, in case of an up counter (1080), the bit of the binary value (T) at the current bit position (N) is set to low and the lower bits of the binary value (T) are set to high. Next, the software module (1022) enables (5006) the counter (1080), whereby the counter (1080) varies the count value (CNT). After a given time-period, the software module disables (5008) the counter (1080) and determines (5010) whether one or more bits of the count value (CNT) have a respective expected value. When at least one of the one or more bits of the count value (CNT) does not have the respective expected value, the software module (1022) signals (5020) a malfunction of the digital hardware counter circuit (108). Otherwise, the software module (1022) selects a next bit position (N) of the plurality of most significant bits of the count value (CNT).

## Description

### Technical field

The present disclosure relates to safety mechanisms within processing systems employed in safety-critical domains, such as the automotive field. More specifically, it pertains to counter circuits, e.g., of Software Watchdog Timers (SWDT).

### Background

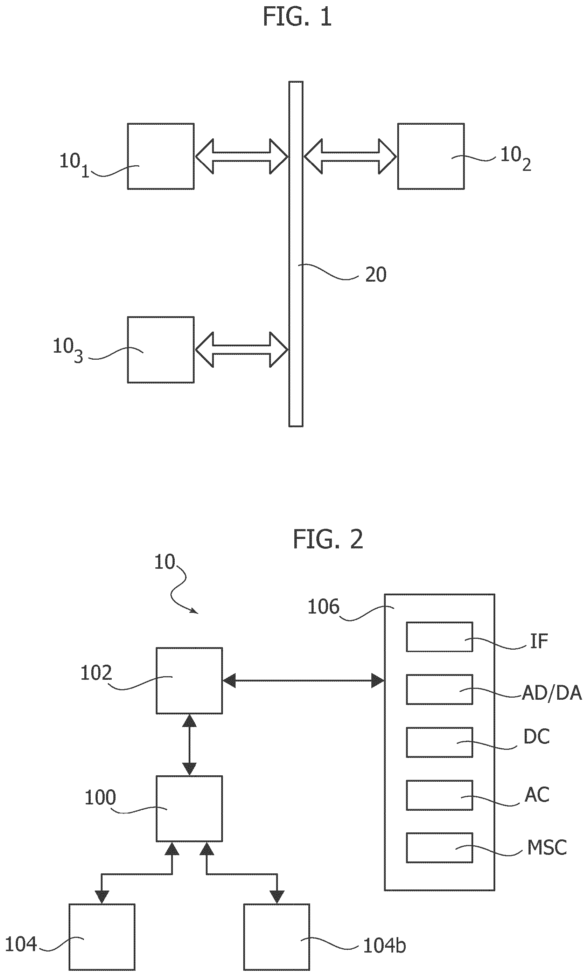

Figure 1 shows a typical electronic system, such as the electronic system of a vehicle, comprising a plurality of processing systems 10, such as embedded systems or integrated circuits, e.g., a Field Programmable Gate Array (FPGA), a Digital Signal Processor (DSP) or a micro-controller (*e.g.*, dedicated to the automotive market).

For example, in Figure 1 are shown three processing systems 10₁, 10₂ and 10₃ connected through a suitable communication system 20. For example, the communication system may include a vehicle control bus, such as a Controller Area Network (CAN) bus, and possibly a multimedia bus, such as a Media Oriented Systems Transport (MOST) bus, connected to vehicle control bus via a gateway. Typically, the processing systems 10 are located at different positions of the vehicle and may include, e.g., an Engine Control Unit, a Transmission Control Unit (TCU), an Anti-lock Braking System (ABS), a Body Control Module (BCM), and/or a navigation and/or multimedia audio system. Accordingly, one or more of the processing systems 10 may also implement real-time control and regulation functions. These processing systems are usually identified as Electronic Control Units.

Figure 2 shows a block diagram of an exemplary digital processing system 10, such as a micro-controller, which may be used as any of the processing systems 10 of Figure 1.

In the example considered, the processing system 10 comprises a microprocessor 102, usually the Central Processing Unit (CPU), programmed via software instructions. Usually, the software executed by the microprocessor 102 is stored in a non-volatile program memory 104, such as a Flash memory or EEPROM. Thus, the memory 104 is configured to store the firmware of the processing unit 102, wherein the firmware includes the software instructions to be executed by the microprocessor 102. Generally, the non-volatile memory 104 may also be used to store other data, such as configuration data, e.g., calibration data.

The microprocessor 102 usually has associated also a volatile memory 104b, such as a Random-Access-Memory (RAM). For example, the memory 104b may be used to store temporary data.

As shown in Figure 2, usually the communication with the memories 104 and/or 104b is performed via one or more memory controllers 100. The memory controller(s) 100 may be integrated in the microprocessor 102 or connected to the microprocessor 102 via a communication channel, such as a system bus of the processing system 10. Similarly, the memories 104 and/or 104b may be integrated with the microprocessor 102 in a single integrated circuit, or the memories 104 and/or 104b may be in the form of a separate integrated circuit and connected to the microprocessor 102, e.g., via the traces of a printed circuit board.

In the example considered, the microprocessor 102 may have associated one or more (hardware) resources/peripherals 106 selected from the group of:
- one or more communication interfaces IF, *e.g.*, for exchanging data via the communication system 20, such as a Universal asynchronous receiver/transmitter (UART), Serial Peripheral Interface Bus (SPI), Inter-Integrated Circuit (I²C), Controller Area Network (CAN) bus, and/or Ethernet interface, and/or a debug interface; and/or
- one or more analog-to-digital converters AD and/or digital-to-analog converters DA; and/or
- one or more dedicated digital components DC, such as hardware timers and/or counters, such as one or more hardware and/or software watchdog timers; and/or
- one or more analog components AC, such as comparators, sensors, such as a temperature sensor, etc.; and/or
- one or more mixed signal components MSC, such as a PWM (Pulse-Width Modulation) driver.

Accordingly, the digital processing system 10 may support different functionalities. For example, the behavior of the microprocessor 102 is determined by the firmware stored in the memory 104, *e.g.*, the software instructions to be executed by a microprocessor 102 of a micro-controller 10. Thus, by installing a different firmware, the same hardware (micro-controller) can be used for different applications.

In this respect, safety-critical systems demand robust mechanisms to detect and respond to faults promptly. Traditional hardware watchdog timers serve this purpose at the hardware level. Similarly, in software-intensive systems, a dedicated Software Watchdog Timer, SWDT, may be useful. Specifically, a SWDT acts as a sentinel, continuously monitoring via a counter the execution of software tasks or processes. It relies on receiving periodic signals from the monitored unit such as, for example, a software module. Accordingly, if these signals cease due to a fault or hang the SWDT intervenes, for example by restarting the monitored software module or the microprocessor 102. In general, counter or timer circuits may also be used for other safety-critical applications. For example, United States Patent Application no. US 2019/0041440 A1 discloses solutions for monitoring a clock signal via a counter.

In order to comply with the Automotive Safety Integrity Level, ASIL, defined by the ISO 26262 standard, such safety-critical counters should be tested. For example, the inventors have observed that, in order to verify the integrity of a counter of a (e.g., watchdog) timer circuit, the counter may be set to an initial value and the system may wait that the timer expires when the counter reaches a final value. For example, in case of a down-counter, the count value may be set to an initial value having all bits set to '1' and the final count value may be zero. Accordingly, in this way the counting operation between the minimum and the maximum value of the counter may be tested.

However, this approach is inherently time-intensive and thus only suitable for low-resolution counters, e.g., having 8 or 16 bits. Conversely, with an increasing bit number, the time-period may become too long in order to ensure a boot time, which should usually be smaller than 50 milliseconds.

Accordingly, the present invention relates to a method for testing a digital hardware counter circuit according to the preamble of Claim 1, which is known, e.g. from document US 4,860,325 A. Documents US 5,473,651 A, US 4,991,185 A and US 5,930,186 A may also be of interest for the present invention.

### Object and summary

In view of the above, various embodiments of the present disclosure provide improved solutions for testing counters in processing systems.

According to one or more embodiments, the above objective is achieved by means of a method having the features specifically set forth in the claims that follow. Embodiments moreover concern a related processing system and as well as a corresponding computer program product, which can be loaded into the memory of at least one microprocessor and comprises portions of software code for implementing the steps of the method when the product is run on the microprocessor. As used herein, reference to such a computer program product is understood as being equivalent to reference to a computer-readable means containing instructions for controlling a processing system in order to co-ordinate execution of the method. Reference to "at least one microprocessor" is clearly intended to highlight the possibility of the present disclosure being implemented in a distributed/modular way.

The scope of protection is defined in the appended claims, which are an integral part of the technical teaching of the disclosure provided herein.

As mentioned before, various embodiments of the present disclosure relate to solutions for testing a digital hardware counter circuit. In various embodiments, the digital hardware counter circuit, forms part of a processing system, e.g., integrated in an integrated circuit. In various embodiments, the processing system comprises also a microprocessor connected to the digital hardware counter circuit and a non-volatile memory storing the firmware to be executed by the microprocessor. Accordingly, the processing system may be a micro-controller and the digital hardware counter circuit may belong to a timer circuit, such as a watchdog timer, such as a software watchdog timer for the microprocessor.

In various embodiments, the counter circuit comprises a register configured to store a count value and a digital down or up counter, wherein the digital down or up counter is configured to determine whether a signal indicates that the digital down or up counter is enabled or disabled. For example, the signal may be provided via a respective enabled flag of the register.

In response to determining that the signal indicates that the digital counter is enabled, the digital counter varies the count value. Specifically, a down counter decreases the count value according to a step size in response to a clock signal. Conversely, an up counter increases the count value according to a step size in response to a clock signal. For example, in various embodiments, the clock signal of the counter corresponds to the clock signal of the microprocessor. Accordingly, in various embodiments, the count value has a given number of bits and is either increased or decreased. For example, in various embodiments, the step size may be programmable via the register and/or may be set to one.

In various embodiments, the digital counter determines whether the count value reaches a final value. In response to determining that the count value reaches the final value, the digital counter asserting a trigger signal. In various embodiments, the final value is programmable via the register. Moreover, in various embodiments, the processing system may be programmable in order to configure whether the trigger signal is provided as reset and/or interrupt signal to the microprocessor.

Specifically, in various embodiments, in order to test the counter circuit, the microprocessor is configured to execute a software module, e.g., the software module may be stored to the non-volatile memory of the processing system. Specifically, in various embodiments, the software module is configured to test a plurality of most significant bits of the count value by repeating a sequence of steps for each bit position of the plurality of most significant bits of the count value.

For example, in various embodiments, the count value may have 16, 32 or 64. In various embodiments applied to a 16-bit counter, the number of most significant bits may be selected in a range between 8 and 16 bits, preferably between 8 and 14 bits, more preferably between 8 and 12 bits, e.g., 10, 11 or 12 bits. In various embodiments applied to a 32-bit counter, the number of most significant bits may be selected in a range between 16 and 32 bits, preferably between 16 and 30 bits, more preferably between 16 and 28 bits, e.g., 24, 25 or 26 bits. In various embodiments applied to a 64-bit counter, the number of most significant bits may be selected in a range between 32 and 64 bits, preferably between 32 and 62 bits more preferably between 32 and 60 bits, e.g., 56, 57 or 58 bits.

Specifically, the software module writes the register of the counter circuit to set the count value to a binary value. For example, in various embodiments, the count value may be set by programming directly the count value stored to the register or by writing an initial value to the register, which is transferred to the count value, once the counter is reset. In this phase, the counter is preferably stopped. Specifically, in various embodiments relating to a down counter, the bit of the binary value at the (current) bit position is set to high and the lower bits of the binary value are set to low. Conversely, in various embodiments relating to an up counter, the bit of the binary value at the (current) bit position is set to low and the lower bits of the binary value are set to high. In general, the higher bits may have any value. For example, in various embodiments, the most significant bits of the binary value are set to low for a down counter, and high for an up counter.

In various embodiments, the software module then enables the digital counter, whereby the digital counter varies the count value. Next, the software module disables the digital counter. In various embodiments, the software module is configured to disable the digital counter immediately with the next software instruction or after a given time-period, which may be implemented, e.g., by executing one or more "nop" operation.

In various embodiments, the software module then determines whether one or more bits of the count value have a respective expected value. For example, in case of a down counter, the software module may determine whether the bit at the (current) bit position is low or, in case of an up counter, determine whether the bit at the (current) bit position is high. In various embodiments, the software module may also verify one or more lower and/or higher bits of the count value. For example, in case of a down counter, the software module may determine whether one or more bits of the count value at lower bit positions compared to the (current) bit position are set to high. Conversely, in case of an up counter, the software module may determine whether one or more bits of the count value at lower bit positions compared to the (current) bit position are set to low. Additionally or alternatively, the software module may determine whether one or more bits of the count value at higher bit positions compared to the (current) bit position remained unchanged. For example, in various embodiments, in case the (current) bit position corresponds to the bit position of the most significant bit of the count value, the software module may determine whether all bits of the plurality of most significant bits of the count value have a respective expected value.

Accordingly, in various embodiments, in response to determining that at least one of the one or more bits of the count value does not have the respective expected value, the software module may signal a malfunction of the digital hardware counter circuit. Conversely, in response to determining that each of the one or more bits of the count value does have the respective expected value, the software module selects a next bit position of the plurality of most significant bits of the count value. For example, in various embodiments, the software module tests the plurality of most significant bits of the count value by starting with the bit position of the most significant bit of the count value and selecting as next bit position the next lower bit position of the plurality of most significant bits of the count value.

Accordingly, the previous operations permit to sequentially test a given number of most significant bits of the count value. In various embodiments, in order to test the remaining least significant bits of the count value, the software module enables again the digital counter and determines whether the count value reaches the final value and/or the digital counter asserts the trigger signal. In various embodiments, prior to enabling the digital counter, the software module may set the count value to an initial value, which ensures that the value of each of the least significant bits of the count value flips at least once when counting from the initial value to the final value. For example, in case of a down counter, the final value may correspond to zero and the initial value may correspond to a bit sequence having the plurality of most significant bits of the count value set to low, and (at least) the most significant bit of the remaining least significant bits of the count value set to high. Conversely, in case of an up counter, the initial value may correspond to zero and the final value may correspond to a bit sequence having the plurality of most significant bits of the count value set to low, and (at least) the most significant bit of the remaining least significant bits of the count value set to high.

For example, in various embodiments, the software module may determine whether the digital counter asserts the trigger signal within a given period of time. For this purpose, the trigger signal may be provided as interrupt signal to the microprocessor and the software module may monitor the interrupt signal. In response to determining that the digital counter asserts the trigger signal, the software module may determine whether the count value corresponds to the final value. Accordingly, in response to determining that the digital counter does not assert the trigger signal or the count value does not correspond to the final value, the software module may signal a malfunction of the digital hardware counter circuit.

### Brief description of the drawings

Embodiments of the present disclosure will now be described with reference to the annexed drawings, which are provided purely by way of non-limiting example and in which:
- Figure 1 shows an example of an electronic system comprising a plurality of processing systems;
- Figure 2 shows an example of a processing system, such as a microcontroller;
- Figure 3 shows a processing system comprising a counter testing unit in accordance with the solution here described;
- Figure 4 shows a method for testing a counter in accordance with the solution here described;
- Figure 5 shows a counter register of a down-counter being tested in accordance with the solution here described; and
- Figure 6 shows a counter register of an up-counter being tested in accordance with the solution here described.

### Detailed description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The reference provided herein are for convenience only and do not interpret the scope or meaning of the embodiments.

As mentioned before, various embodiments of the present disclosure provide solutions for testing a counter.

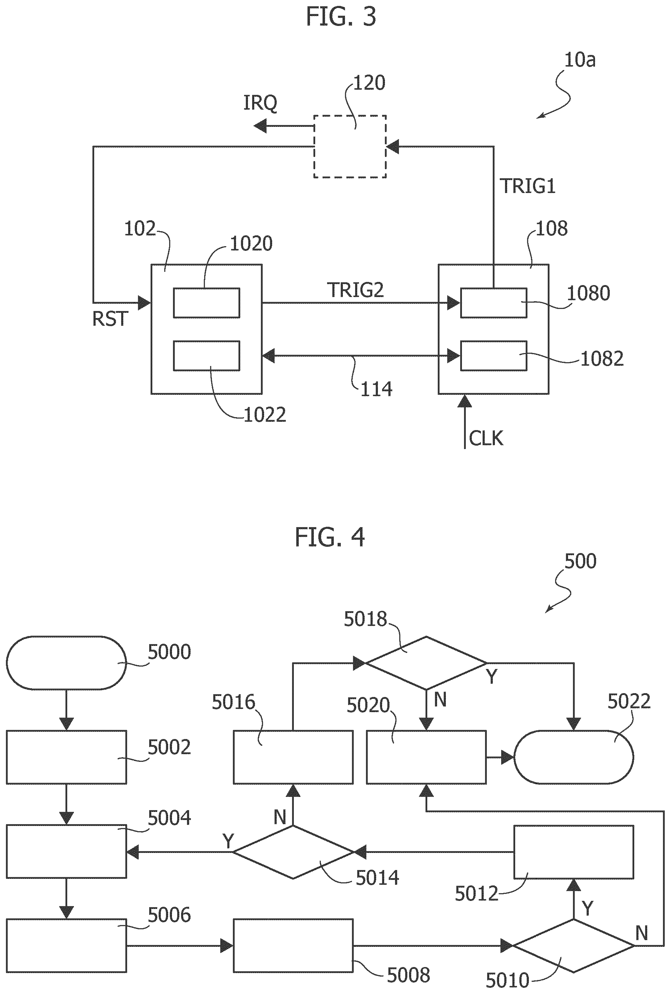

Figure 3 shows an embodiment of a processing system 10a comprising a microprocessor 102 and a timer circuit 108, such as a watchdog timer, e.g., a software watchdog timer. In the embodiment considered, the timer circuit 108 comprises a counter 1080 and one or more registers 1082.

Specifically, in various embodiments, the microprocessor 102 may read and write the register(s) 1082 via software instructions executed by the microprocessor 102. For example, for this purpose, the timer circuit 108 may be connected via a suitable (e.g., on-chip) communication system 114 to the microprocessor 102. For example, in various embodiments, the microprocessor 102 comprises a master communication interface configured to forward read and write requests from the microprocessor 102 to the communication system 114, and forward a response from the communication system 114 to the microprocessor 102. In various embodiments, the timer circuit 108 is connected to the communication system 114 via a slave communication interface, e.g., comprising a register interface and/or a peripheral bridge. For example, for this purpose, the communication system 114 may indeed comprise an Advanced Microcontroller Bus Architecture (AMBA) High-performance Bus (AHB), and an Advanced Peripheral Bus (APB) used to connect the timer circuit 106 to the AMBA AHB bus. For example, in this way, the microprocessor 102 may send a write and read request to the timer circuit 108 in order to write and read the content of the register(s) 1082, e.g., by including an address associated with a given register 1082 in the write or read request.

For example, in various embodiments, the register(s) 1082 may be used to start/enable the digital hardware counter 1080. Specifically, in response to being enabled, the counter 1080 varies a count value in response to a clock signal CLK, i.e., increases the count value for an up-counter, or decreases the count value for a down-counter). In various embodiments the count value is stored to the register(s) 1082.

In various embodiments, in order to implement a timer, the counter 1080 may be configured to start counting from an initial value until a final value is reaches. In various embodiments, at least one of these values is programmable via the register 1082. For example, in case of an up-counter, the initial value may be fixed to zero and the final value may be programmable via the register 1082. Conversely, in case of a down-counter, the initial value may be programmable via the register 1082 and the final value may be zero. However, also both values may be programmable.

In various embodiments, the counter 1080 is increased (or decrease) by a count step of one. However, in various embodiments, also the count step may be programmable via the register(s) 1082.

Accordingly, in various embodiments, once the counter 1082 is enabled/started, the counter 1080 varies the count value with a given count step size starting from the initial value. In parallel the counter 1080 determines whether the count value reaches the final value. In response to determining that the count value has reached the final value, the counter 1080 generates a trigger signal TRIG1.

For example, in case of a conventional hardware timer, the trigger signal TRIG1 is usually provided as an interrupt signal to the microprocessor 102. Conversely, in order to implement a watchdog timer, the trigger signal TRIG1 is provided as a reset signal RST to the microprocessor 102. In various embodiments, the reaction to the trigger signal TRIG1 may be programmable. For example, in various embodiments, the processing system 10a comprises also a (programmable) fault collection and error management circuit 120 configured to generate one or more reset signals RST and optionally one or more interrupt signals IRQ as a function of a plurality of error signals. Accordingly, in this case, the trigger signal TRIG1 may correspond to an error signal provided to the fault collection and error management circuit 120. Alternatively, the reaction type, e.g., interrupt or reset, may be programmable via the register(s) 1082, e.g., via a respective interrupt enable flag and/or reset enable flag.

Accordingly, in order to implement a software watchdog timer, one or more software modules 1020 executed by the microprocessor 102 are configured to reset the timer circuit 108 before the counter 1080 reaches the final value. For example, in various embodiments, the software instruction(s) executed by the microprocessor 102 may reset the timer circuit 108 by programming the register 1082 and/or via a dedicated trigger signal TRIG2 provided to the counter 1080. Accordingly, in response to a reset, the counter 1080 is configured to (re)set the count value again to the initial value and then continue with the counting operation.

Accordingly, in various embodiments, when the software module 1020 fails (or the software modules fail) to reset the timer circuit 108, the counter 1080 will reach the final value and generate the trigger signal TRIG1, which in turn may be configured, e.g., to reset the microprocessor 102.

In various embodiments, in addition to or as alternative to being reset by the microprocessor 102, a software watchdog timer 108 may also directly monitor the operation of the microprocessor 102 in order to evaluate whether the microprocessor 102 is operating correction, e.g., by monitoring and analyzing the value of the program counter of the microprocessor 102.

As mentioned before, various embodiments of the present disclosure provide solutions for testing a counter 1080, e.g., the counter 1080 of the timer circuit 108, such as a hardware or software watchdog timer.

Specifically, in various embodiments, the microprocessor 102 executes a counter testing software module 1022, i.e., the firmware of the microprocessor 102 (e.g., stored to the memory 104) comprises the software instructions of the counter testing software module 1022 (and optionally the software instructions of the software module 1020).

Specifically, in various embodiments, the counter testing module 1022 is configured to verify that the timer circuit 108 is operating correctly, in particular by testing the counter 1080 comprised therein. In this regard, the counter testing module 1020 is configured to test thoroughly the functionality of the timer circuit 108, and to report any malfunction as it occurs. In various embodiments, the counter testing module 1022 may be employed to test other circuits employing a counter different from the timer circuit 108.

In various embodiments, the timer testing module 1022 can be loaded and executed by the microprocessor 102 whenever the processing system 10a necessitates to verify whether the timer circuit 108 operates correctly. For example, the timer testing module 1022 may be loaded and executed during a bootstrap phase of the processing system 10a, at periodic intervals, or upon request, for instance for debugging or diagnostic purposes.

Specifically, when executed by the microprocessor 102, the software instructions of the counter testing module 101 cause the microprocessor 102 to implement a method 500 for testing a counter.

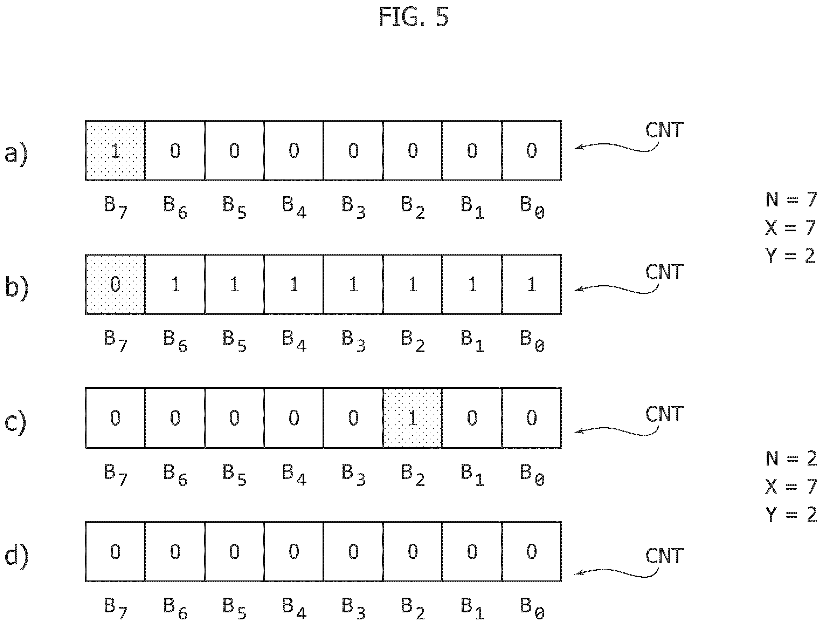

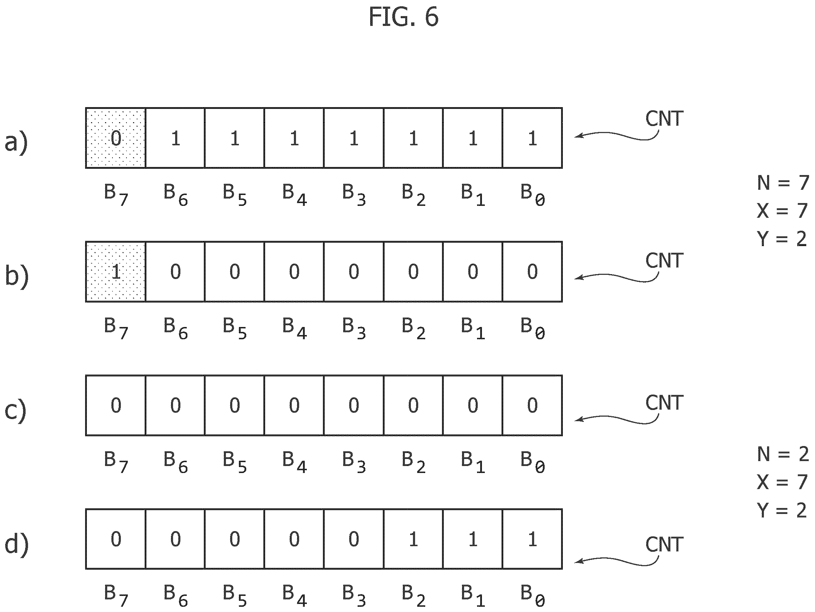

In this regard, Figure 4 shows a flowchart of an embodiment of the method 500 for testing a counter. In particular, the solution here described encompasses a method for testing a hardware digital counter which, according to the considered embodiments of the present solution, can be either a down-counter or an up-counter. In order to provide a deeper understating, the present solution is described with reference made to an exemplary 8-bit down-counter, whose corresponding register, e.g., the register 1082, comprises 8 bits for storing a respective count value CNT and is illustrated in Figure 5. Additionally, references are made also to an exemplary 8-bit up-counter, whose corresponding register comprises 8 bits and is illustrated in Figure 6.

Accordingly, in the embodiment considered, as shown, e.g., in Figures 5a and 6a, the register arranged to store the count value CNT comprises 8 bits, which are numbered starting from 0 to 7 as shown by the labels B₀...B₇, wherein the bit B₇ corresponds to the Most Significant Bit (MSB) and the bit B₀ corresponds to the Least Significant Bit (LSB). In various embodiments, the method described herein can be used to assess the functionality of counters comprising a different number of bits, such as 16, 32 or 64 bit counters. Hence the example shall not be interpreted in a limiting sense.

After a starting step 5000, in a step 5002 an index N is initialized to a first value. Substantially, the index N indicates the current bit position of a bit of the count value CNT to be tested. For example, in various embodiments, the testing starts with the MSB bit, e.g., the bit B₇ for an 8-bit counter, wherein the index N is set to a value to indicate the MSB bit. For example, in various embodiments, the index N is set to the bit index X of the MSB bit. For example, since the index of the LSB bit is usually zero, the index N may be set to the total number of bits of the count value CNT minus 1, e.g., 7 for an 8-bit counter. Thus, in the example considered the index N is set to 7 in step 5002. In general, the testing may also start with any other bit, such as the LSB bit, whereby the index N may be set to zero.

Next, in a step 5004 the method sets the count value CNT to a binary value T having the same number of bits as the count value CNT and. For example, for this purpose the testing module 1022 may program the register 1082 via a write request.

In particular, in embodiments relating to the testing of down-counters, the value T has set to '1' (high) the bit indicated by the index N, e.g., the MSB, e.g., bit B₇, and all lower bits (compared to the bit position N) set to '0' (low). In general, the higher bits (compared to the bit position N) may be set to any value, but preferably also the higher bits are set to '0'. For example, in various embodiments, the value T written to the count value CNT during the step 5004 is equal to 2^N, where N denotes the index of the bit which is to be analyzed. For example, a possible configuration of the count value CNT after performing such step 5004 in an 8-bit down-counter is illustrated in Figure 5a, where the count value CNT is set to the binary value "1000000".

On the other hand, in embodiments relating to the testing of up-counters the value T has set to '0' the bit indicated by the index N, e.g., the MSB, e.g., bit B₇, and all lower bits (compared to the bit position N) set to '1'. In general, the higher bits (compared to the bit position N) may be set to any value, but preferably also the higher bits are set to '1'. For example, in various embodiments, the value T written to the count value CNT of an up-counter is equal to 2^N - 1. For example, a possible configuration of the count value CNT after performing such step 5004 in an 8-bit up-counter is illustrated in Figure 6a, where the count value CNT is set to the binary value '01111111'.

Next, in a step 5006 the counter is enabled in such a way that is starts counting, e.g., by programming the register 1082. In particular, upon the reception of a starting signal, a down-counter starts counting in a descending order, hence decrementing by 1 (or a given step size) the binary number of the count value CNT each time a clock pulse is detected. Conversely, an up-counter starts counting in ascending order, incrementing by 1 (or a given step size) the binary number of the count value CNT each time a clock pulse is detected.

Next, in a step 5008, the counter is left running for a predetermined amount of time and, after the predetermined amount of time is elapsed, the counter 1080 is stopped, e.g., by writing the register 1082. In general, the amount of time the counter is left running is chosen in such a way to allow the counter to decrease, or increase, the count value CNT at least once. For example, based on the clock frequency of the microprocessor and the clock frequency of the clock signal CLK used by the counter 1080, the software module 1022 may execute a given number of nop (no operation) instructions or other software instructions, which do not interfere with the counting operation of the counter 1080. In case the clock frequency of the counter 1080 corresponds at least to the clock frequency of the microprocessor, the step 5008 may also immediately stop the counter 1080, because the counter 1080 counts at least once while a single software instruction is executed by the microprocessor 102.

For example, possible count values CNT after the step 5008 are illustrated in Figures 5b and 6b, respectively showing cases relating to a down-counter and an up-counter.

Next, in a step 5010, the counter value CNT is read, e.g., by reading the register 1082, and one or more bits of the count value CNT are compared to expected values. Specifically, in various embodiments, the testing module 1022 is configured to determine whether the bit at the index N has a respective expected value. In various embodiments, the testing module 1022 is also configured to determine whether the bit at the index N-1 has a respective expected value. Similarly, the testing module 1022 may determine whether one or more of (and possibly all) the higher and/or lower bits have a respective expected value.

For example, in embodiments relating to the testing of down-counters with a step size of one, the expected value of the bit of the count value CNT at position N is equal to '0', whereas the expected value of the bit of the count value CNT at position N-1 (and possible further other lower bits) is equal to '1'. Conversely, in embodiments relating to the testing of up-counters with a step size of one, the expected value of the bit of the count value CNT at position N is equal to '1', whereas the expected value of the bit of the count value CNT at position N-1 (and possible further other lower bits) is equal to '0'. Conversely, the value of the higher bits remains usually unchanged.

Thus, in various embodiments, in step 5010 the value of the bit at position N and optionally the value of one or more lower bits of the count value CNT are compared to respective expected values. Substantially, compared to the value T, the expected values of the bit N and the lower bits are flipped. Accordingly, in various embodiments, the software module 1022 may be configured to verify whether the bit or bits have flipped i.e., changed value from '0' to '1' and, vice versa, from '1' to '0'.

In various embodiments, also the values of one or more higher bits of the count value CNT are compared to respective expected values. Specifically, compared to the value T, the expected values of the higher bits should remain unchanged. Accordingly, in various embodiments, the software module 1022 may be configured to verify whether one or more of the higher bits remained unchanged.

In response to determining that at least one of the one or more bits of the count value CNT does not have the respective expected value (output "N" of the verification step 5010), e.g., at least one of the bits at the positions N and N-1 have not flipped, the method continues in an error step 5020, where a malfunction of the counter is signaled, and the method ends at a stop step 5022.

Conversely, in response to determining that each of the one or more bits of the count value CNT have the respective expected value (output "Y" of the verification step 5010), e.g., both bits at the positions N and N-1 have flipped, the method 500 continues in a step 5012.

Specifically, in step 5012, the value of the index N is varied/modified in order to select a next bit of the count value CNT to be tested, i.e., the current bit position N indicates a next bit position to be tested. For example, when starting with the MSB (step 5002), the variation of the index N may comprise decreasing by one the value of the index N. However, also any other rule may be used to sequentially select a given number of most significant bits of the count value CNT. For example, in various embodiments, the solution here described allows to test counters by checking first the MSB, and then iteratively selecting the following lower bits for testing until the last desired bit is tested.

For example, in various embodiments, while the index X indicates the position of the MSB, an index Y may be used to indicate the position of the last bit of the count value CNT to be tested. For example, letting Y = 0, all the bits of the count value CNT may be tested.

Accordingly, in various embodiments, a given number of most significant bits of the count value CNT are tested. For example, in various embodiments, the count value may have 16, 32 or 64. In various embodiments applied to a 16-bit counter, the number of most significant bits to be tested may be selected in a range between 8 and 16 bits, preferably between 8 and 14 bits, more preferably between 8 and 12 bits, e.g., 10, 11 or 12 bits. In various embodiments applied to a 32-bit counter, the number of most significant bits to be tested may be selected in a range between 16 and 32 bits, preferably between 16 and 30 bits, more preferably between 16 and 28 bits, e.g., 24, 25 or 26 bits. In various embodiments applied to a 64-bit counter, the number of most significant bits to be tested may be selected in a range between 32 and 64 bits, preferably between 32 and 62 bits more preferably between 32 and 60 bits, e.g., 56, 57 or 58 bits.

Accordingly, as will be described in greater detail in the following, in various embodiments, not all bits of the count value CNT are tested via the steps 5004-5010, but only a given number of most significant bits of the count value CNT, wherein this given number is at least two and smaller than the number of bits of the count value CNT, whereby a given number Y of least significant bits are not tested at the steps 5004-5010. For example, in various embodiments, the index/number Y may be 2, 3, 4, 6 or 8. For example, this may be useful when the counter 1080 uses a clock signal CLK having a frequency being equal to or greater than the frequency of the clock signal of the microprocessor 102, because in this way several count operations may be performed by the counter 1080, before the testing model 1022 may stop the counter again at the step 5008.

Accordingly, in a step 5014, the testing module determines whether further bits have to be tested, e.g., whether the first index N is greater than the second index Y.

In response to determining that further bits have to be tested (output "Y" of the verification step 5014), e.g., when N > Y, the testing module 1022 returns to the step 5004, thereby performing a further iteration of the method 500. Accordingly, in various embodiments a given number of most significant bits of the count value CNT are sequentially tested. For example, in the embodiment considered, the testing module 1022 repeats the steps 5004 to 5014 until the index N reaches the value of the index Y i.e., N = Y (or a malfunction is detected at the step 5010).

In various embodiments, the steps 5012 and 5014 may also be inverted, i.e., the testing module 1022 may first determine whether further bits have to be tested and then set the index N to the next value.

Conversely, in response to determining that the given number of MSB bits have been tested (output "N" of the verification step 5014), e.g., when the index N is smaller or equal to the index Y, the method 500 continues in a step 5016.

In general, the step 5016 is purely optional and used when a given number of least significant bits have to be tested separately. Accordingly, in various embodiments, the method may also directly proceed to the stop step 5022. In fact, as mentioned before, the steps 5004 to 5014 test bit flip of a given number of most significant bits of the count value CNT, but the remaining least significant bits (if any) remain unverified, e.g., because it may be impossible to precisely control the count operation of the counter 1080 via software instructions starting (step 5006) and stopping (step 5008) the counter 1080.

Accordingly, in various embodiments, in step 5016 the counting operation of the counter 1080 for the remaining least significant bits should be tested, e.g., the bits comprised between the bit indicated by the index Y and the LSB. For instance, in a counter having the index Y set equal to 2, the last 3 bits should be tested. For this reason, the testing module 1022 sets the count value CNT to a given initial value, starts the counter 1080, and the counter is let running until the counter expires, i.e., reaches a final count value, thereby asserting the trigger signal TRIG1.

Accordingly, the initial value and/or the final value should be selected to ensure that, while the counter is counting from the initial value to the final value, at least one bit flip occurs for each of the remaining least significant bits to be tested.

For example, in various embodiments, a down-counter 1080 may be configured to count from a programmable initial value to a (e.g. fixed) final value corresponding to zero, i.e., the counter generates the trigger signal TRIG1 when all bits of the count value CNT are '0'. Accordingly, in this case, at least the bit at position Y should be set to '1', i.e., the testing module 1022 may set the count value CNT to any value being greater than 2^Y, e.g., at least the bit at position Y may be set to '1', and then start the counter 1080, e.g., by programming the register 1082. For example, this is also shown in Figures 5c and 5d, which show a possible embodiment for the initial value and the final value of the count value CNT for a down-counter with Y = 2. For example, in Figure 5c, the initial value is set to the binary value "0000 0100".

Conversely, in various embodiments, an up-counter 1080 may be configured to count from a (e.g., fixed) initial value corresponding to zero to a programmable final value. Accordingly, in this case, the testing module 1022 may reset the count value CNT and set the final value of the counter 1080 to a value being greater than 2^Y, e.g., having at least the bit at position Y set to '1'. Next, the testing module may start the counter 1080, e.g., by programming the register 1082. For example, this is also shown in Figures 6c and 6d, which show a possible embodiment for the initial value and the final value of the count value CNT for a up-counter with Y = 2. For example, in Figure 6d, the final value is set to the binary value "0000 0111".

Conversely, in case of an up-counter 1080 configured to generate the trigger signal TRIG1 when all bits of the count value CNT are '1' or when an overflow condition is reached, i.e., when the count value CNT reaches zero, the (Y+1) least significant bits of the count value CNT may be set to '0' and the remaining most significant bits of the count value CNT may be set to '1'.

Accordingly, in various embodiments, once the testing module 1022 has programmed the initial value and/or the final value, the testing module 1022 starts the counter 1080. In various embodiments, the setting of the initial and/or final value of the counter 1080 at the step 5016 is purely optional. In fact, when sequentially testing at the step 5004 to 5014 the bits of the counter 1080 from the MSB bit, the count value CNT may already have a suitable value and the testing module 1022 may just start again the counter 1080 at the step 5016.

Accordingly, once having started the counter 1080, the testing module 1022 may verify at a step 5018 whether the counter 1080 reaches the final value. In general, during this operation the processing system 10a, e.g., the fault collection and error management circuit 120, should be configured such that the trigger signal TRIG1 does not generate a reset RST of the microprocessor 102, because otherwise the test would be interrupted.

For example, in various embodiments, the processing system 10a, e.g., the fault collection and error management circuit 120, is configured such that the trigger signal TRIG1 generates an interrupt IRQ of the microprocessor 102. Accordingly, in this case, the testing module 1022 may monitor at the step 5018 the respective interrupt signal.

Additionally or alternatively, in various embodiments, the testing module 1022 may monitor the count value in order to determine whether the count value CNT reached the final value.

Preferably, both operations are combined, i.e., the software module 1022 monitors the interrupt signal IRQ, because this ensures that the counter 1080 is able to generate the trigger signal TRIG1, and then the count value CNT, because this ensures that the trigger signal TRIG1 is generated when the count value CNT reaches the (expected) final value.

Accordingly, when the test shows a failure (output "N" of the verification step 5018), e.g., in response to determining that the interrupt signal IRQ has not been generated or the count value CNT does not reach the final count value, e.g., within a given period of time, the testing module 1022 may proceed to the error step 5020.

Conversely, when the test is successful (output "Y" of the verification step 5018), e.g., in response to determining that the interrupt signal IRQ has been generated and the count value CNT reaches the final count value, the counter is considered to be working correctly and the execution of method 500 terminates at the stop step 5022.

In view of the above, the present solution advantageously provides a software safety check mechanism intended to assess the functionality of a counter by checking whether the bits of the count value CNT have flipped e.g., from 0 to 1 or vice-versa, during the operation of the counter. Specifically, in various embodiments, an individual bit flip of a given number of most significant bits are verified sequentially. Optionally, the operation of the counter for the remaining least significant bits is verified by performing a counting operation for these least significant bits.

Of course, without prejudice to the principle of the solution described herein, the details of construction and the embodiments may vary widely with respect to what has been described and illustrated herein purely by way of example, without thereby departing from the scope of the present solution, as defined by the ensuing claims.

## Claims

1. A method (500) for testing a digital hardware counter circuit (108), wherein the counter circuit (108) comprises a register (1082) configured to store a count value (CNT) and a digital down or up counter (1080), wherein the digital down or up counter (1080) is configured to:
- determine whether a signal indicates that the digital down or up counter (1080) is enabled or disabled,
- in response to determining that the signal indicates that the digital down or up counter (1080) is enabled, vary the count value (CNT) by:
a) in case of a down counter (1080), decreasing the count value (CNT) according to a step size in response to a clock signal (CLK), or
b) in case of an up counter (1080), increasing the count value (CNT) according to a step size in response to a clock signal (CLK),
wherein the count value (CNT) has a given number of bits (X);
- determine whether the count value (CNT) reaches a final value; and
- in response to determining that the count value (CNT) reaches the final value, asserting a trigger signal (TRIG1);
**characterized in that** the method comprises executing the following steps via software instructions executed by a microprocessor (102):
- testing a plurality of most significant bits of the count value (CNT) by repeating the following steps for each bit position (N) of the plurality of most significant bits of the count value (CNT):
- writing (5004) the register (1082) to set the count value (CNT) to a binary value (T), wherein:
a) in case of a down counter (1080), the bit of the binary value (T) at the bit position (N) is set to high and the lower bits of the binary value (T) are set to low, or
b) in case of an up counter (1080), the bit of the binary value (T) at the bit position (N) is set to low and the lower bits of the binary value (T) are set to high;
- enabling (5006) the digital down or up counter (1080), whereby the digital down or up counter (1080) varies the count value (CNT);
- disabling (5008) the digital down or up counter (1080);
- determining (5010) whether one or more bits of the count value (CNT) have a respective expected value, the determining (5010) comprising:
a) in case of a down counter (1080), determining whether the bit at the bit position (N) is low, or
b) in case of an up counter (1080), determining whether the bit at the bit position (N) is high,
- in response to determining that at least one of the one or more bits of the count value (CNT) does not have the respective expected value, signal (5020) a malfunction of the digital hardware counter circuit (108); and
- in response to determining that each of the one of the one or more bits of the count value (CNT) does have the respective expected value, select a next bit position (N) of the plurality of most significant bits of the count value (CNT).

2. The method of Claim 1, wherein:
a) in case of a down counter (1080), the most significant bits of the binary value (T) are set to low, or
b) in case of an up counter (1080), the most significant bits of the binary value (T) are set to high.

3. The method of Claim 1 or Claim 2, wherein the method tests the plurality of most significant bits of the count value (CNT) by starting with the bit position (X) of the most significant bit of the count value (CNT) and selecting as next bit position (N) the next lower bit position of the plurality of most significant bits of the count value (CNT).

4. The method any of the previous claims, wherein the determining (5010) whether one or more bits of the count value (CNT) have a respective expected value, comprises:
a) in case of a down counter (1080), determining whether one or more bits of the count value (CN) at lower bit positions compared to the bit position (N) are set to high, or
b) in case of an up counter (1080), determining whether one or more bits of the count value (CN) at lower bit positions compared to the bit position (N) are set to low.

5. The method any of the previous claims, wherein the determining (5010) whether one or more bits of the count value (CNT) have a respective expected value, comprises:
- in case the bit position (N) corresponds to the bit position of the most significant bit of the count value (CNT), determining (5010) whether all bits of the plurality of most significant bits of the count value (CNT) have a respective expected value.

6. The method any of the previous claims, comprising:
- testing the remaining least significant bits of the count value (CNT) by:
- enabling (5006) the digital down or up counter (1080),
- determining (5018) whether the count value (CNT) reaches the final value and/or the digital down or up counter (1080) asserts the trigger signal (TRIG1).

7. The method of Claim 6, wherein the determining (5018) whether the count value (CNT) reaches the final value and/or the digital down or up counter (1080) asserts the trigger signal (TRIG1) comprises:
- determining whether the digital down or up counter (1080) asserts the trigger signal (TRIG1) within a given period of time;
- in response to determining that the digital down or up counter (1080) asserts the trigger signal (TRIG1), determining whether the count value (CNT) corresponds to the final value;
- in response to determining that the digital down or up counter (1080) does not assert the trigger signal (TRIG1) or the count value (CNT) does not correspond to the final value, signal (5020) a malfunction of the digital hardware counter circuit (108).

8. The method of Claim 6 or Claim 7, wherein the trigger signal (TRIG1) is provided as interrupt signal (IRQ) to the microprocessor (102) and the determining whether the digital down or up counter (1080) asserts the trigger signal (TRIG1) comprises monitoring the interrupt signal (IRQ).

9. The method of any of the previous claims 6 to 8, comprising prior to the enabling (5006) the digital down or up counter (1080), setting the count value (CNT) to an initial value, which ensures that the value of each of the least significant bits of the count value (CNT) flips at least once when counting from the initial value to the final value.

10. The method of Claim 9, wherein:
a) in case of a down counter (1080), the final value corresponds to zero and the initial value corresponds to a bit sequence having the plurality of most significant bits of the count value (CNT) set to low, and the most significant bit of the remaining least significant bits of the count value (CNT) set to high; or
a) in case of an up counter (1080), the initial value corresponds to zero and the final value corresponds to a bit sequence having the plurality of most significant bits of the count value (CNT) set to low, and the most significant bit of the remaining least significant bits of the count value (CNT) set to high.

11. A processing system (10) comprising:
- a digital hardware counter circuit (108);
- a microprocessor (102) connected to the digital hardware counter circuit (108);
- a non-volatile memory (104) storing a computer-program product to be loaded into the memory of the microprocessor (102), wherein the computer program comprises portions of software code that, when executed by the microprocessor, implement the steps of the method according to any of Claims 1 to 10.

12. A computer-program product that can be loaded into the memory of at least one processor (102), wherein the computer program comprises portions of software code that, when executed by the at least one processor, implement the steps of the method according to any of Claims 1 to 10.
